(19) **Europäisches Patentamt**
**European Patent Office**
**Office européen des brevets**

(11) **EP 4 517 587 A1**

(12) **EUROPEAN PATENT APPLICATION**

(43) Date of publication:
05.03.2025 Bulletin 2025/10

(21) Application number: 24194641.7

(22) Date of filing: 14.08.2024

(51) International Patent Classification (IPC):
*G06N 3/045* (2023.01)      *G06N 3/08* (2023.01)
*G06T 17/00* (2006.01)

(52) Cooperative Patent Classification (CPC):
**G06N 3/045; G06N 3/08; G06T 17/00;**
G06T 2210/04

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: 29.08.2023 US 202318457854

(71) Applicant: Autodesk, Inc.
San Francisco, CA 94105 (US)

(72) Inventors:
• **Hassani, Kaveh**
  **Thornhill, Toronto, L4J 6J1 (CA)**
• **Cheong, Hyunmin**
  **Vaughan, Toronto, L4K 3G2 (CA)**
• **Arnold, Adam Noble**
  **Berkeley, 94708 (US)**
• **Malekshan, Kamal Rahimi**
  **North York, Toronto, M2N 7J7 (CA)**

(74) Representative: **Keller Schneider**
**Patentanwaltsgesellschaft mbH**
**Linprunstraße 10**
**80335 München (DE)**

(54) **REPRESENTATION LEARNING OF MODEL DATA**

(57) A method and system provide the ability to utilize three-dimensional (3D) models to perform a predictive task. Multiple 3D models, consisting of non-Euclidean data, are obtained. Each 3D model is translated into a relational graph with nodes and edges. Each relational graph is processed using a graph neural network (GNN) that computes a node representation per node. The node representations are aggregated into a structural representation of the 3D model. Multiple different views of the 3D model are captured and passed through a convolutional neural network (CNN) to compute a view representation of each view. The view representations are aggregated into a single visual representation. The GNN and CNN are trained using a multiview contrastive training objective to maximize agreement between the structural representation and the single visual representation to form final learned representations. The final learned representation is utilized to perform the predictive task.

**FIG. 14**

```
OBTAIN MULTIPLE 3D MODELS          1402
            ↓
TRANSLATE EACH 3D MODEL            1404
INTO A RELATIONAL GRAPH
            ↓
PROCESS EACH RELATIONAL GRAPH      1406
INTO NODE REPRESENTATIONS
            ↓
AGGREGATE NODE REPRESENTATIONS     1408
            ↓
CAPTURE MULTIPLE DIFFERENT VIEWS   1410
OF 3D MODEL
            ↓
COMPUTE VIEW REPRESENTATION OF     1412
EACH VIEW
            ↓
AGGREGATE VIEW REPRESENTATIONS     1414
INTO SINGLE VISUAL REPRESENTATION
            ↓
GENERATE FINAL LEARNED             1416
REPRESENTATION
            ↓
UTILIZE FINAL LEARNED              1418
REPRESENTATION TO PERFORM
PREDICTIVE TASK
```

EP 4 517 587 A1

**Description**

BACKGROUND OF THE INVENTION

1. Field of the Invention.

The present invention relates generally to two-dimensional (2D) and three-dimensional (3D) building information models (BIM), and in particular, to a method, apparatus, system, and article of manufacture for enabling deep learning of BIMs. Such deep learning includes the processing of a small set of exemplary BIMs to identify and cluster data and information (of such exemplary BIMS) to provide an expressive representation of the BIM models. The expressive representations enable smart features such as clustering, classifying, recommending, or searching/retrieving BIM models.

2. Description of the Related Art.

(Note: This application references a number of different publications as indicated throughout the specification by reference numbers enclosed in brackets, e.g., [x]. A list of these different publications ordered according to these reference numbers can be found below in the section entitled "References." Each of these publications is incorporated by reference herein.)

Building information model (BIM) software (such as REVIT BIM software available from the assignee of the present invention) helps architecture, engineering and construction (AEC) teams create high-quality buildings and infrastructure. BIMs are complex and contain information (e.g., in metadata and otherwise) about the structure and appearance of elements in the models. When designing a new building, users manually search through a database of previously designed BIM models to identify relevant content and/or find similar designs that can serve as a template/-foundation. Such a prior art search process is slow and inefficient. What is needed is quick and efficient mechanism to search and/or identify elements and designs that can be used in the design process. To better understand such problems, a description of prior art BIM applications and limitations may be useful.

BIM software can: model shapes, structures, and systems in three dimensions (3D) with parametric accuracy, precision, and ease; streamline documentation work, with instant revisions to plans, elevations, schedules, and sections as projects change; and empower multidisciplinary teams with specialty toolsets in a unified project environment. BIM models contain rich information about semantic, geometric, and visual characteristics of a building model designed by architects. In other words, BIM models are complex and contain irregular data structures that can be analyzed from different perspectives such as appearance, structure, semantics, etc.

It may be desirable to utilize deep learning to generate and search for BIMs. Deep learning is a machine learning technique that teaches computers to do what comes naturally to humans: learn by example. In deep learning, data is organized into layers and input data (e.g., exemplary images) is transformed into slightly more abstract and composite representations at each layer. The word "deep" in deep learning refers to the number of layers through which data is transformed. By processing data at each layer/level, a deep learning process can learn which features to optimally place in which level on its own. Unfortunately, the irregular data structures and complexity of BIMs makes BIMs incompatible with regular deep learning architectures that expect well-defined input structures. In this regard, it is not a trivial task to query information about BIM models or feed such models into deep models for predictive tasks. Moreover, BIM models are treated as independent files and the rich patterns across models are ignored.

To better understand the problems of the prior art, it may be useful to describe deep learning for images. Suppose it is desirable to categorize an image of a cat as a cat (e.g., instead of as a dog). Systems may process the cat image through a deep convolutional network (DCN) (also known as a deep convolutional neural network [DCNN] or convolutional neural network [CNN]). A DCN/DCNN/CNN is a class of artificial neural network that is used to analyze visual imagery and uses convolution in at least one of the layers. To process new images, several exemplary images of cats and dogs are input into the DCN and the DCN learns the representations. In this regard, based on the DCN processing, a set of numbers (e.g., [0.7, -0.1, 0.4, 0.3, -0.4, -0.1, -0.3]) are assigned to represent the image (e.g., different features/attributes of the images are transformed/translated into the numerical representations).

Similar processing can be done for objects/elements other than just images (e.g., product reviews). To process such other objects/elements, a network other than DCN may be utilized. For example, deep learning may utilize a long/short term memory (LSTM) network/system to categorize a product review as a good review, very good review, bad review, or very bad review.

While DCNs and LSTMs may be used in deep learning for standard images, BIM models are complex. For example, BIM models may have text, floor plans, structural information, electrical information, mechanical information, etc. It may be desirable to categorize/classify a BIM model as residential or commercial but neither DCN or LSTM networks may be used due to the complexity. In this regard, standard images or text that may be classified via a DCN or LSTM network include Euclidean/structured data. In contrast, BIM models contain non-Euclidean or irregular structured data. Non-Euclidean/irregular structured data may exist in a variety of different environments such as in 3D solid models, chemical structures, graph structures, 3D architectural models, etc. However, none of these irregular structured data environments can be processed by traditional deep learning models due to these irregularities.

In view of the above, the prior art fails to provide the capability to feed BIM models into deep learning models to learn expressive representations of such models. To provide such a capability, the following questions need to addressed: (1) how to structure BIM models in order to feed them into deep models; (2) what aspects of BIM models should be considered; and (3) what deep architectures are the best fit for BIM models.

## SUMMARY OF THE INVENTION

To overcome the problems of the prior art, embodiments of the invention use a combination of preprocessing steps including translating BIM models to graph structures and 2D structures and recent advances in deep learning including self-supervised learning and multimodal learning to map a BIM model into a dense vector representation using a stack of deep models. Learning such expressive representations over BIM models enables smart features such as clustering, classifying, recommending, or retrieving BIM models.

In other words, one of the goals of embodiments of the invention is to learn task-agnostic representations (e.g., set of numbers) of BIM models from limited input data (i.e., with limited access to exemplary input examples) such that the learned representations can be adapted to new tasks based on a small training sample set (e.g., a few examples in which the training is based).

## BRIEF DESCRIPTION OF THE DRAWINGS

Referring now to the drawings in which like reference numbers represent corresponding parts throughout:

FIG. 1 illustrates sample building information models (BIMs) utilized to train models in accordance with one or more embodiments of the invention;

FIG. 2 illustrates the structural representation of a BIM model in accordance with one or more embodiments of the invention;

FIG. 3 illustrates an exemplary structural representation in accordance with one or more embodiments of the invention;

FIG. 4 illustrates an exemplary complex structural representation for a BIM model in accordance with one or more embodiments of the invention;

FIG. 5 illustrates the distributions of the number of nodes and edges for the graphs of FIG. 1 in accordance with one or more embodiments of the invention;

FIGs. 6A and 6B illustrate the frequencies of exemplary extracted element categories (FIG. 6A) and relation categories (FIG. 6B) in accordance with one or more embodiments of the invention;

FIG. 7 illustrates the process for generating the graph representation in accordance with one or more embodiments of the invention;

FIG. 8 illustrates the logical flow for capturing the visual representation of the BIM model in accordance with one or more embodiments of the invention;

FIG. 9 illustrates the multimodal representation that consists of the combination of the structural representation and visual representation in accordance with one or more embodiments of the invention;

FIGs. 10A-10C illustrate exemplary processes for transferring learning in accordance with one or more embodiments of the invention;

FIG. 11 illustrates an exemplary general implementation of a training pipeline using AMAZON WEB SERVICES in accordance with one or more embodiments of the invention;

FIG. 12 illustrates a more specific implementation of the training pipeline using a graph neural network (GNN) in accordance with one or more embodiments of the invention;

FIG. 13 illustrates an exemplary GNN inference pipeline for utilizing the GNN to classify and infer attributes about a BIM model in accordance with one or more embodiments of the invention;

FIG. 14 illustrates the logical flow for utilizing 3D models to perform a predictive task in accordance with one or more embodiments of the invention;

FIG. 15 is an exemplary hardware and software environment used to implement one or more embodiments of the invention; and

FIG. 16 schematically illustrates a typical distributed/cloud-based computer system in accordance with one or more embodiments of the invention.

DETAILED DESCRIPTION OF THE INVENTION

In the following description, reference is made to the accompanying drawings which form a part hereof, and which is shown, by way of illustration, several embodiments of the present invention. It is understood that other embodiments may be utilized and structural changes may be made without departing from the scope of the present invention.

Overview

BIM models contain rich information about semantic, geometric, and visual characteristics of a building model designed by architects. However, it is not a trivial task to query information about them or feed them into deep models for predictive tasks. Moreover, BIM models are treated as independent files and the rich patterns of cross models are ignored. To address these issues, embodiments of the invention represent BIM models as directed and attributed multi graphs (also known as relational graphs). Once this translation is done, it is possible to feed the graphs into graph neural networks (GNNs) to classify them, predict some of the missing attributes, cluster them, or recommend them. Providing such features to BIM models can enhance the user experience.

In general, self-supervised learning is used to generate task-agnostic representations of a BIM model (i.e., self-supervised provides for conducting learning without human based annotations/input). Multimodality is then used to augment multi-view data (i.e., multiple different aspects of a BIM model are used simultaneously/at the same time). Relational inductive bias is used for sample efficiency (i.e., preexisting relations that exist in BIM models may be utilized), and transfer learning is used to provide a quick adaptation (i.e., learning from one trained model/task may be transferred to another model/task - e.g., from representing a model with certain parts to a cost model [e.g., a model for costing the physical construction of the model in the real world]).

Methodology

*Overview*

In order to process and feed BIM models into deep models, embodiments of the invention consider two modalities to represent the models. The first modality represents the BIM models as relational structures (i.e., directed attributed graphs) with the goal to capture the underlying structure of a BIM model. The second modality captures the appearance of the BIM models. The first modality is fed into a Graph Neural Network (GNN) to compute a structural representation of a given model and the second modality is fed into a Multiview Convolutional Neural Network (MVCNN) [1] to compute a visual representation of a given model. In order to train the GNN and the MVCNN models, embodiments of the invention use a multi-view contrastive training objective to maximize the agreement between the structural and visual representations of a same BIM model and push apart the structural and visual representations of different BIM models. Once the training is done, embodiments of invention can treat the learned representations as the representation of the original BIM model and use it for downstream tasks such as classification, regression, or similarity search across the BIM models.

*Exemplary Dataset*

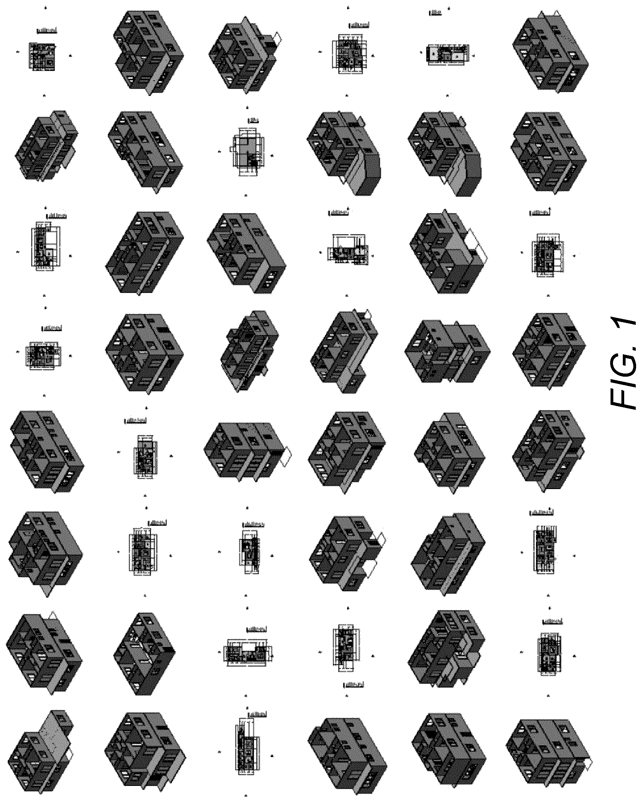

Embodiments of the invention utilized 360 BIM models of Japanese houses. These models are toy Japanese house of one or two stories. Some sample models are as shown in FIG. 1.

*Structural Representation*

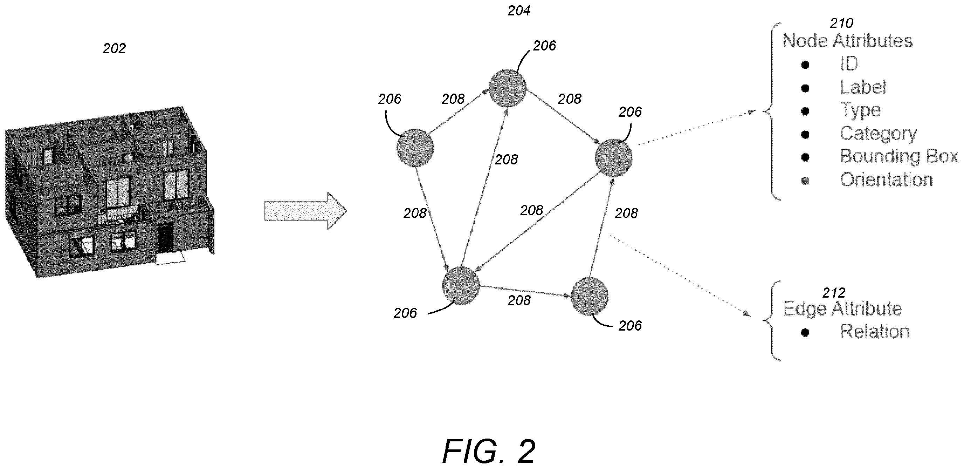

FIG. 2 illustrates the structural representation of a BIM model in accordance with one or more embodiments of the invention. In order to compute the structural representations of the BIM models 202, embodiments of the invention first translate each BIM model 202 into a relational graph 204 such that the nodes 206 correspond to the elements within the BIM models 204 and the edges 208 correspond to a type of relation between pairs of nodes 206. Embodiments of the invention attribute each graph by extracting the node attributes 210 (e.g., ID, label, type, category, bounding box, and orientation of each element) within a given BIM model 202 and assigning a dedicated node 206 for that element with those properties. Similarly, the graph attributing process includes extracting/defining the edge attributes 212 that defines a relation between each of the nodes 206 (e.g., made of). The resulting graph 204 provides a conceptual view of the BIM model 202.

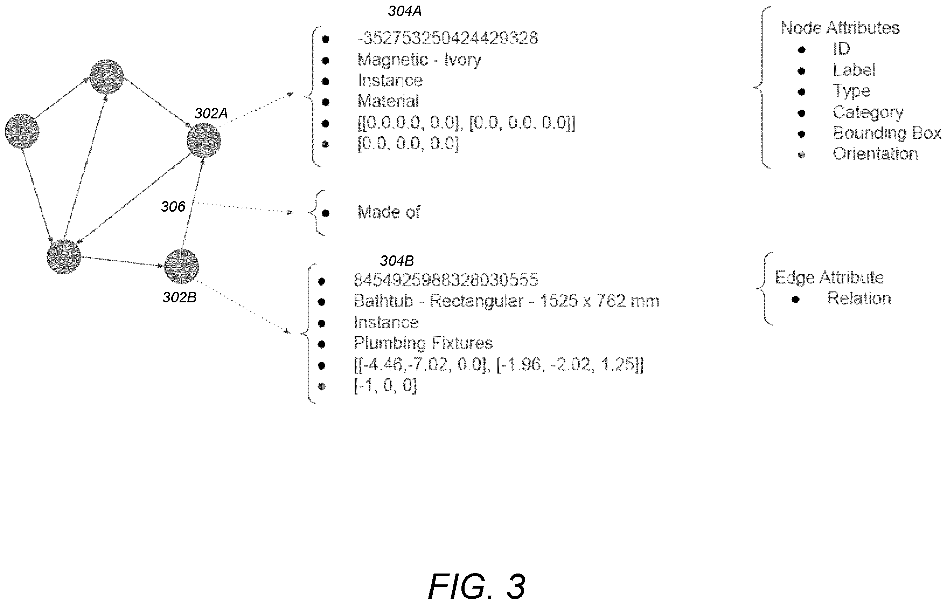

FIG. 3 illustrates an exemplary structural representation in accordance with one or more embodiments of the invention. As illustrated, two nodes 302A and 302B have their node attributes 304A and 304B extracted/defined. Node 304A has an ID of "-352753250424429328", a label of "Magnetic-Ivory", a type of "Instance", a Category of "Material", a bounding box defined by [[0.0, 0.0, 0.0],[ 0.0, 0.0, 0.0]], and an orientation of [0.0, 0.0, 0.0]. Node 304B has the following node attributes: ID - "8454925988329030555"; Label - "Bathtub - Rectangular - 1525x762mm"; Type - "Instance"; Category - "Plumbing Fixtures"; Bounding Box - [[-4.46, -7.02, 0.0], [-1.96, -2.02, 1.25]]"; and Orientation - "[-1, 0, 0]". Further one edge attribute 306 has been defined/extracted and provides (via the edge attribute relation) that node 304B is "Made of" node 304A (i.e., the bathtub represented by node 304B is made of the material represented by node 304A). The extracted relation is visually represented in the structural representation via the arrow pointing from node 302B to node 302A. Thus, FIG. 3 graphically provides for a bathtub plumbing fixture represented by node 302B that is connected to node 302A that specifies the material (i.e., Magnetic-Ivory) that the bathtub is made of.

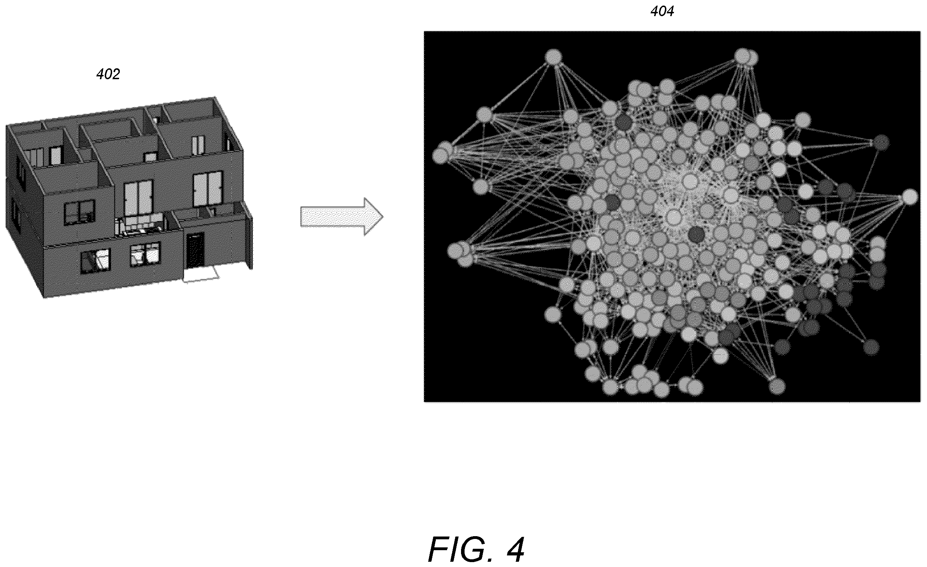

The graph is FIG. 3 provides a simple example of a BIM model structural representation. Many BIM models may be significantly more complex. FIG. 4 illustrates an exemplary complex structural representation 404 for a BIM model 402. As can be seen, the graph 404 is very dense with nodes and edges overlapping.

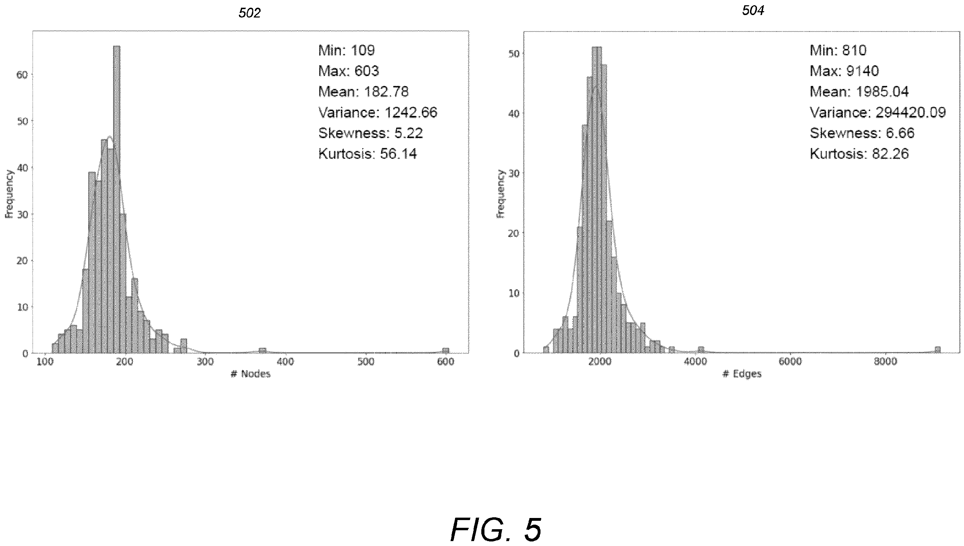

Once all of the BIM models (e.g., all of the examples in FIG. 1) have been translated to their graph representations, embodiments of the invention will have a graph per BIM model. FIG. 5 illustrates the distributions of the number of nodes 502 and edges 504 for the graphs of FIG. 1 in accordance with one or more embodiments of the invention. The vertical axis represents the frequency (per graph) while the horizontal axis represents the number of nodes/edges (per graph).

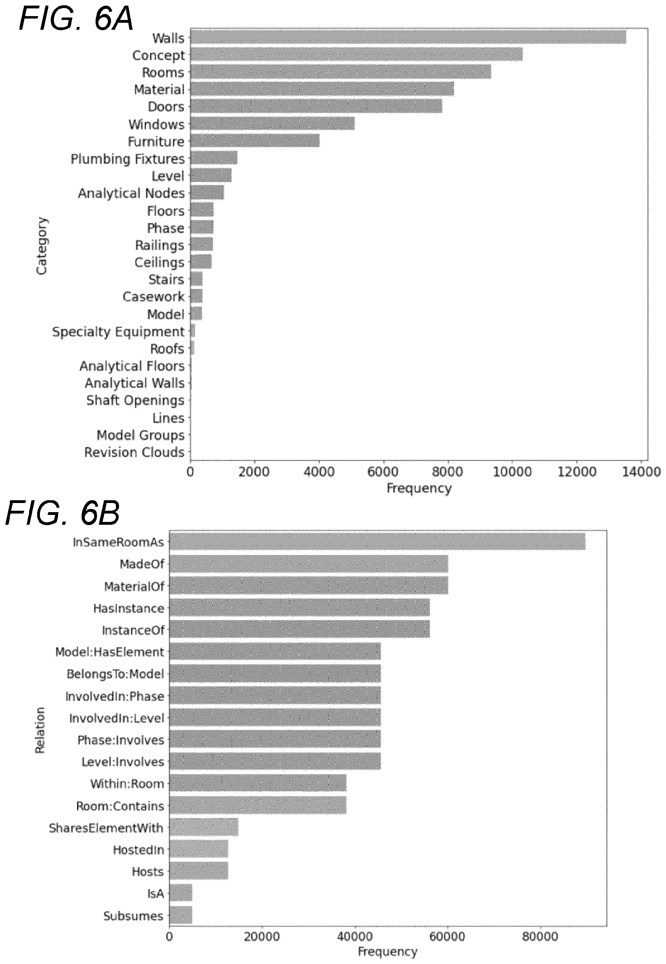

In order to define the relations/types of relations (i.e., the edges 208/306), a set of heuristics may be utilized. FIGs. 6A and 6B illustrate the frequencies of exemplary extracted element categories (FIG. 6A) and relation categories (FIG. 6B) in accordance with one or more embodiments of the invention. In one or more embodiments, sing the set of heuristics, the eighteen (18) exemplary relations specified in FIG. 6B were derived. The following illustrate relations using the derived relations of FIG. 6B:

- Element *A* is MADE_OF material *M*

- Element A is WITHIN ROOM R

- Element A is INVOLVED _IN_PHASE P

- Element *A* is INVOLVED _IN_LEVEL *L*

- Element A is IN_SAME_ROOM_AS Element *B*

- Element A is HOSTED _BY Element *B*

In such relations, the "Element" can be replaced with any derived element category (e.g., the element categories identified in FIG. 6A).

Once the BIM models have been translated to graph structures, a GNN (Graph Neural Network) may be utilized to compute a representation per node in each graph. To compute such a representation, a GNN learns representations based on connectivity and node/edge attributes. A strong connectivity inductive bias generates sample efficiency.

The node representations may then be aggregated into a graph level representation which is basically the structural representation of the input BIM model. Embodiments of the invention may utilize Graph Isomorphism Network (GIN) [2] layers to construct the GNN.

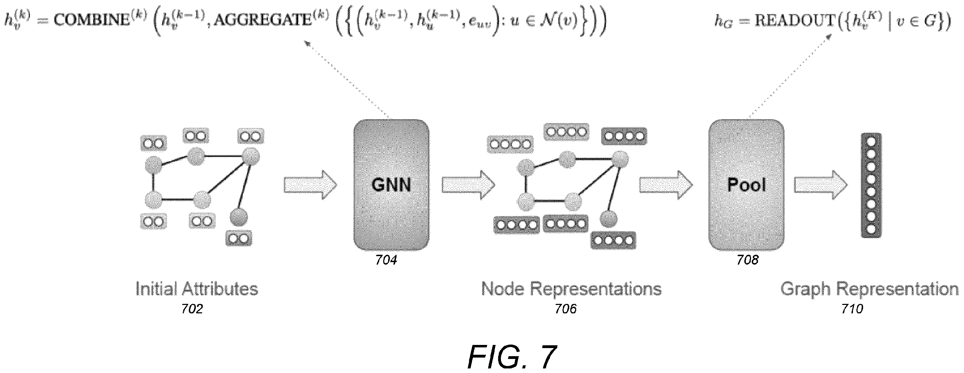

FIG. 7 illustrates the process for generating the graph representation in accordance with one or more embodiments of the invention. As illustrated, the initial attributes 702 are input and used/processed by the GNN 704 (which may be implemented/constructed using a GIN) to generate node representations 706. The GNN 704 may process the initial attributes 702 based on the following equation:

$$h_v^{(k)} = \text{COMBINE}^{(k)} \left( h_v^{(k-1)}, \text{AGGREGATE}^{(k)} \left( \left\{ \left( h_v^{(k-1)}, h_u^{(k-1)}, e_{uv} \right) : u \in N(v) \right\} \right) \right)$$

where G = (V;E) denotes a graph with node feature vectors $X_v$ for $v \in V$. There are two tasks of interest: (1) Node classification, where each node $v \in$ V has an associated label $y_v$ and the goal is to learn a representation vector $h_v$ of v such that v's label can be predicted as $y_v = f(h_v)$; (2) Graph classification, where, given a set of graphs $\{G_1, ..., G_N\} \subseteq$ G and their labels $\{y_1, ..., y_N\} \subseteq Y$, embodiments of the invention aim to learn a representation vector $h_G$ that helps predict the label of an entire graph, $y_G = g(h_G)$. The GNN may use the graph structure and node features $X_v$ to learn a representation vector of a node, $h_v$, or the entire graph, $h_G$. Further, the GNN follows neighborhood aggregation, where the representation of a node is iteratively updated by aggregating representations of its neighbors. After k iterations of aggregation, a node's representation captures the structural information within its k-hop network neighborhood. In the equations above, $h_v^{(k)}$ is the feature vector of node v at the k-th iteration/layer. N(v) is a set of nodes adjacent to v.

The node representations 706 are then pooled 708 to generate the graph representation 710. The pooling may be based on
$$h_G = READOUT\left(\left\{h_v^{(K)}\middle| v \in G\right\}\right)$$
, where the READOUT function aggregates node features from the final iteration to obtain the entire graph's representation $h_G$.

In view of the above, embodiments of the invention use the GNN 704 to attempt to fit a graph into a deep model where the node representations 706 are learned. In this regard, the GNN may consist of a message passing technique where graph nodes (e.g., beginning with the initial attributes 702) iteratively update their representations by exchanging information with their neighbors (resulting in the node representations 706). The node representations 706 are aggregated and a neural network is used to group similar elements to generate the graph representation 710.

*Visual Representation*

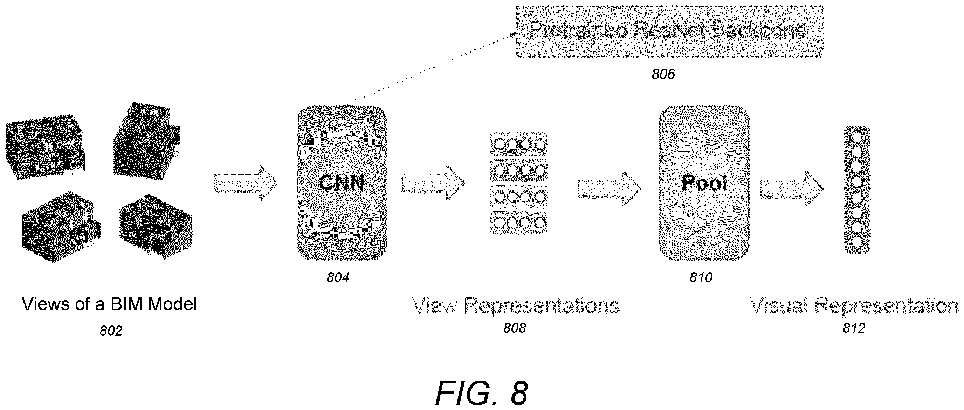

Once the structure of the BIM model has been captured, it is desirable to capture the model's appearance. In this regard, the appearance of a BIM model is also an important aspect of the model. FIG. 8 illustrates the logical flow for capturing the visual representation of the BIM model in accordance with one or more embodiments of the invention.

To capture the visual representation information, embodiments of the invention take a specified number (e.g., 12) of snapshots/views of a three-dimensional (3D) model of a given BIM model with different camera angles 802 and then feed the snapshots into a pre-trained CNN (convolutional neural network) architecture 804. In this regard, embodiments of the invention may utilize a pretrained ResNet backbone 806 trained on ImageNet to compute the visual representation 808 of each snapshot 802. Once all view representations 808 are computed (e.g., one snapshot/view representation 808 per BIM model view 802), embodiments of the invention aggregate/pool 810 them into single visual representation 812 corresponding to the appearance of the input BIM model.

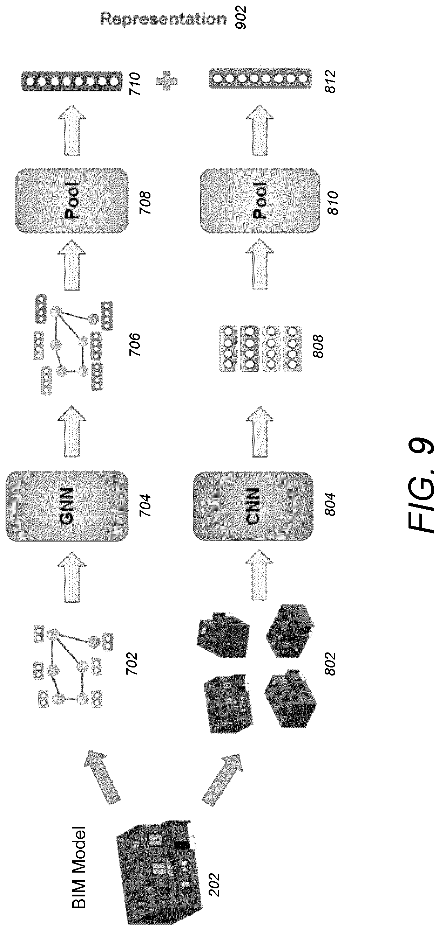

To create the final (multi-modal) representation of the BIM model, information from both the structural view (i.e., the graph representation 710) and the appearance view (i.e., the visual representation 812) are utilized/summarized to generate the final representation. FIG. 9 illustrates the multimodal representation 902 that consists of the combination of the structural representation 710 and visual representation 812 in accordance with one or more embodiments of the invention.

*Training*

To train the model, embodiments of the invention utilize contrastive training. Contrastive training utilizes the principle of contrasting samples against each other to learn attributes that are common between data classes and attributes that set apparat a data class from another. In embodiments of the invention, the model is trained by pushing the model to detect whether a graph is coming from a BIM model and whether images from the BIM model belong to the same model or not. The notion of closeness in vector space is utilized to push images closer together/further apart. For example, if the graph structure is coming from BIM model 1, and twelve (12) images are from BIM model 2, the model is trained to push the images apart because they are not from the same model. If the images are from the same BIM model, then the system pushes the images closer together. In other words, contrastive training maximizes agreement between images belonging to a particular model.

More specifically, it is assumed that the system does not have access to ground-truth labels of any task during the training. The framework is trained end-to-end using deep InfoMax (e.g., with a Jensen-Shannon MI estimator) and maximizing the mutual information (MI) between the visual representations 708 and structural representations 812 following the objective:

$$\max_{\phi,\theta} \frac{1}{|\mathcal{R}|} \sum_{i,j \in \mathcal{R}} \left[ \mathrm{I}\left(h_v^i, h_s^j\right) + \mathrm{I}\left(h_v^j, h_s^i\right) \right]$$

where $\phi, \theta$ are parameters of GNN and MVCNN to be learned, $h_v^i, h_s^j$ denote visual representations of BIM model $i$ and structural representations of BIM model $j$, respectively. I is the mutual information estimator. Embodiments of the invention may utilize the Jensen-Shannon MI estimator:

$$I(h_v, h_s) = \mathbb{E}_p\left[-\log(1 + \exp\left(-\mathcal{D}(h_v, h_s)\right))\right] - \mathbb{E}_{px\tilde{p}}\left[1 + \exp\left(\mathcal{D}(h_v, h_{\tilde{s}})\right)\right]$$

where $\mathcal{D}(.,.)\colon \mathbb{R}^{d_h}\mathrm{X}\mathbb{R}^{d_h} \to \mathbb{R}$ is a discriminator that takes in a node and a graph representation and scores the agreement between them and is implemented as $(-\mathcal{D}(h_v, h_s) = h_n.h_s^T$ . Embodiments of the invention provide the positive samples from the joint distribution (p) and the negative samples from the product of marginals $px\bar{p}$, and optimize the model parameters with respect to the objective using mini-batch stochastic gradient descent.

*Transfer Learning*

Once the GNN and MVCNN models have been trained end-to-end in a self-supervised manner, these two models can be treated as encoders that can encode the underlying knowledge across the BIM models. Thus, once the model is primed with such knowledge, the models can be adapted to new tasks by only providing the encoder with a few examples. These tasks may consist of adapting to classify the BIM models, predicting properties of such models, or using the models for clustering and similarity searching.

In other words, using self supervised learning, weights can be used and tweaked to further train the models and map inputs to outputs. In this regard, rather than starting with a random starting point, the knowledge of the base is transferred to the learning network making it possible to adapt prior classifications to new tasks based on just a few examples.

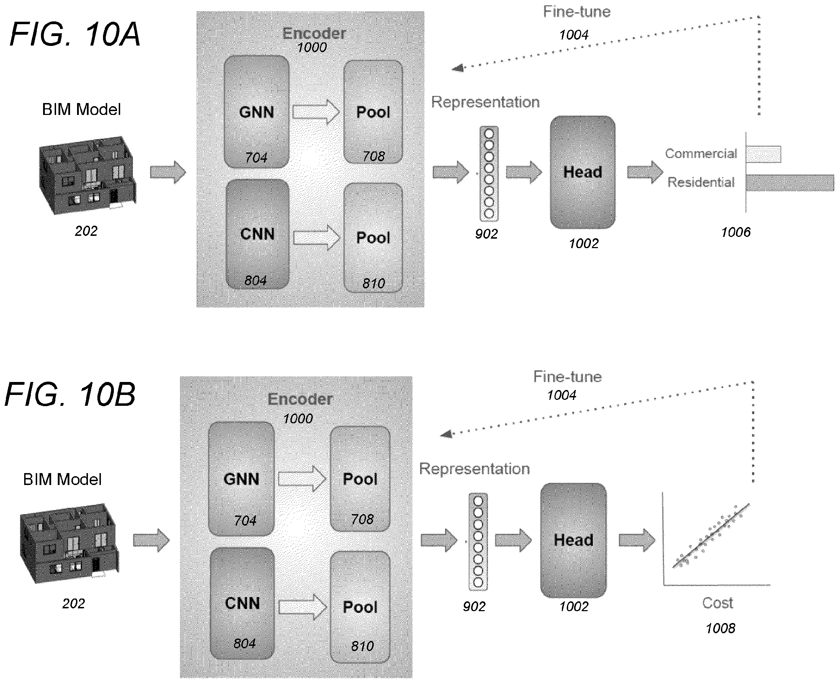

FIGs. 10A-10C illustrate exemplary processes for transferring learning in accordance with one or more embodiments of the invention. FIGs. 10A-10C all illustrate the encoder 1000 that provides the multimodal representation/contrastive training for both the structural representation using the GNN 704 and the visual representation using the CNN 804 that combine to generate the multimodal representation 902. Further the head 1002 of the multimodal representation 902 is used to identify the target of the predictive task at hand. This could be for example, predicting the type of building or its estimated price. In other words, the head 1002 is used to predict different information based on the downstream task.

In FIG. 10A, the multimodal representation 902 is used to classify the BIM model 202 as commercial or residential 1006. The automated self-tuning automatically fine tunes 1004 this classification over time to improve the accuracy of the encoder 1000 in classifying future BIM models 202. In this regard, the search space for automated engineering tools may be reduced. Further, in FIG. 10A, the head 1002 predicts the building type (e.g., whether it is commercial or residential).

In FIG. 10B, the multimodal representation 902 is used to determine the construction cost 1008 of the BIM model 202 (i.e., predicting the final cost 1008 for building a project in the final form given an initial design of the BIM model 202). The automated self-tuning automatically fine tunes 1004 the cost over time to improve the accuracy of the encoder 1000 in costing future BIM models 202. Further, in FIG. 10B, the head 10002 predicts the estimated cost of the building model.

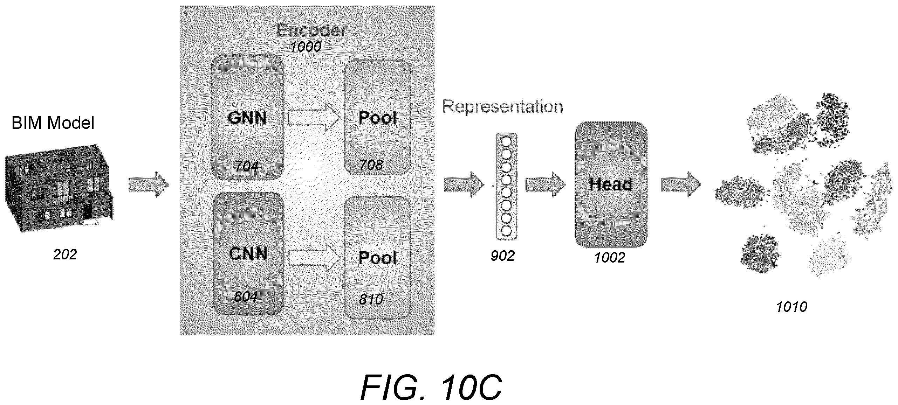

In FIG. 10C, the multimodal representation 902 is used to determine the clustering for similarity searching 1010 of the BIM model 202. In other words, a pre-trained network is used to cluster representations (e.g., vectors or numbers) to cluster BIM models 202 based on similarities. The automated self-tuning automatically fine tunes the clustering over time to improve the accuracy of the similarity searching 1010 for future BIM models 202. Further, in FIG. 10C, the head 1002 identifies similar building elements within the building.

*Implementation and Training Pipeline*

In view of the above, various libraries and BIM modeling application add-ons may be created to extract information from BIM models, analyze the BIM models (e.g., using neural network models), and to visualize the results. A cloud pipeline may also be used to (i) preprocess train and inference data, and (ii) train and serve neural network models.

Training and inference pipelines may be implemented in a variety of manners. An exemplary implementation may utilize the AMAZON WEB SERVICES (AWS) CLOUD using AWS CLI (command line interface). Exemplary training pipeline services may include batch and SAGEMAKER. Inference pipeline services may include SAGEMAKER, LAMBDA, and an API (Application Programming Interface) Gateway. Further, PYTHON may be utilized to provide API access to a BIM modeling application.

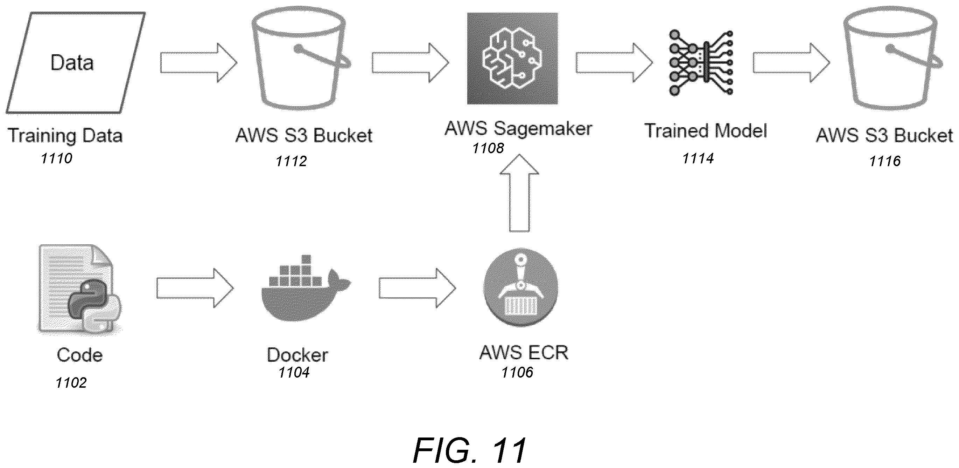

FIG. 11 illustrates an exemplary general implementation of a training pipeline using AWS in accordance with one or more embodiments of the invention. As illustrated, code 1102 is written and packaged as a docker image 1104. In this regard, docker 1104 is a software platform that allows users to build, text, and deploy applications quickly. Docker 1104 packages software (e.g., code 1102) into standardized units called containers that have everything the software needs to run including libraries, system tools, code, and runtime. The docker 1104 is utilized by AMAZON WEB SERVICES (AWS) ELASTIC CONTAIN REGISTRY (ECR) 1106 which is a fully managed container registry offering high performance hosting to enable the reliable deployment of application images and artifacts anywhere.

The AWS ECR 1106 if provided wo the AWS SAGEMAKER 1108 which is software that builds, trains, and deploys machine learning (ML) models for any use case with fully managed infrastructure, tools, and workflows.

Simultaneously with writing the code 1102 and packaging it as a docker image 1104, training data 1110 is provided to the AWS S3 BUCKET 1112 (AWS simple storage service (S3) bucket that serves as a container for objects stored in AMAZON S3. The data 1110 in the AWS S3 Bucket 112 is also provided to the AWS SAGEMAKER 11108.

The AWS SAGEMAKER 1108 is utilized to generate the trained model 1114 which is stored in another AWS S3 BUCKET 1116.

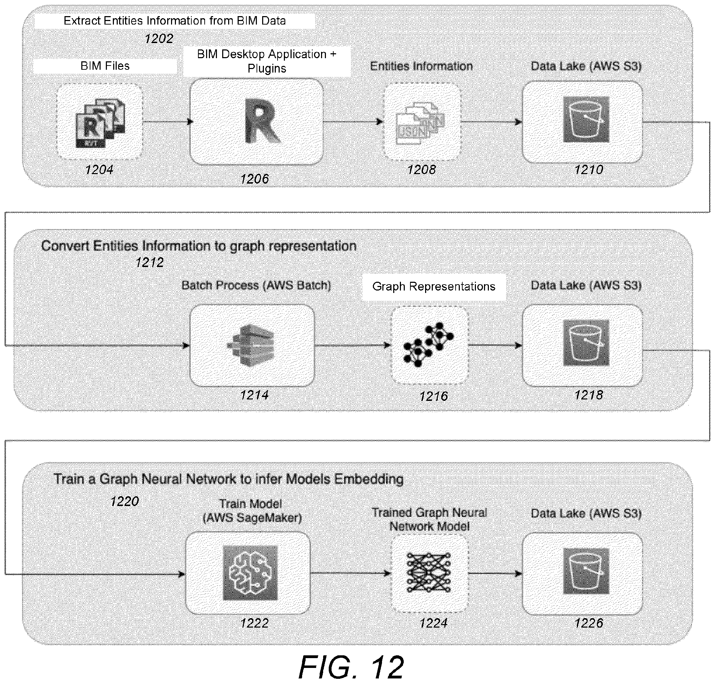

FIG. 12 illustrates a more specific implementation of the training pipeline using a GNN in accordance with one or more embodiments of the invention. The first part 1202 of the training pipeline is that of extracting entity information from BIM/REVIT model data. In this regard, REVITBIM files 1204 are utilized by a BIM modeling application 1206 (e.g., the REVIT desktop application and plugins) to extract entity information 1208 which are then stored/provided to a data lake 1210 such as an AWS S3 bucket.

The next part 1212 of the process is to convert the entity information 208 to a graph representation. In this regard, a Batch process 1214 (e.g., an AWS Batch process) is used to generate the graph representations 1216 that are then stored in a data lake 1218 (e.g., an AWS S3 bucket).

The next step 1220 is to train the graph neural network (GNN) to infer models embedding. In this regard, the graph representations 1216 (stored in data lake 1218) are provide to a model training application 1222 (e.g., AWS SAGEMAKER) that generated a trained graph neural network (GNN) model 1224 that may also be exported/stored in a data lake 1226.

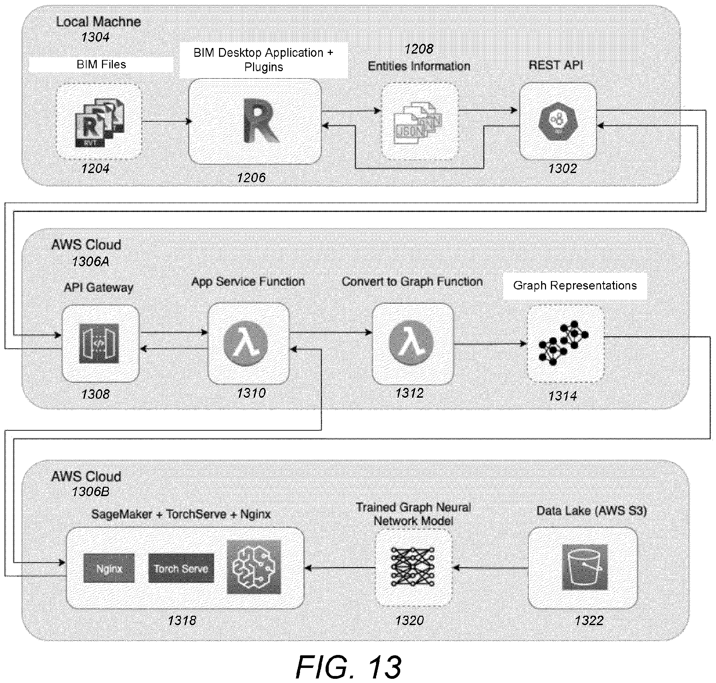

Further to the above, FIG. 13 illustrates an exemplary GNN inference pipeline for utilizing the GNN to classify and infer attributes about a BIM model. The local machine 1304 performs the entity extraction processing 1202 via utilization of a restful API 1302. The graph representations 1216/1314 may be generated in a cloudl based processing system 1306A (e.g., the AWS CLOUD via an API gateway 1308, app service functions 1310 (e.g., via a serverless, event-driven compute service such as AWS LAMBDA) and a convert to graph function 1312 (that may also be implemented via a serverless, event-driven compute service). Cloud based processing 1306B may then process the graph representations 1216/1314 via multiple servers/processing functions 1318 (e.g., AWS SAGEMAKER + TORCHSERVE (a tool for serving PYTHON TORCH models - where TORCH is a framework for deep learning) +NGINX (a load balancer, web server, and reverse proxy)). The servers/processing functions 1318 may also receive input of the trained GNN model 1320 that was stored in a data lake 1322.

Logical Flow

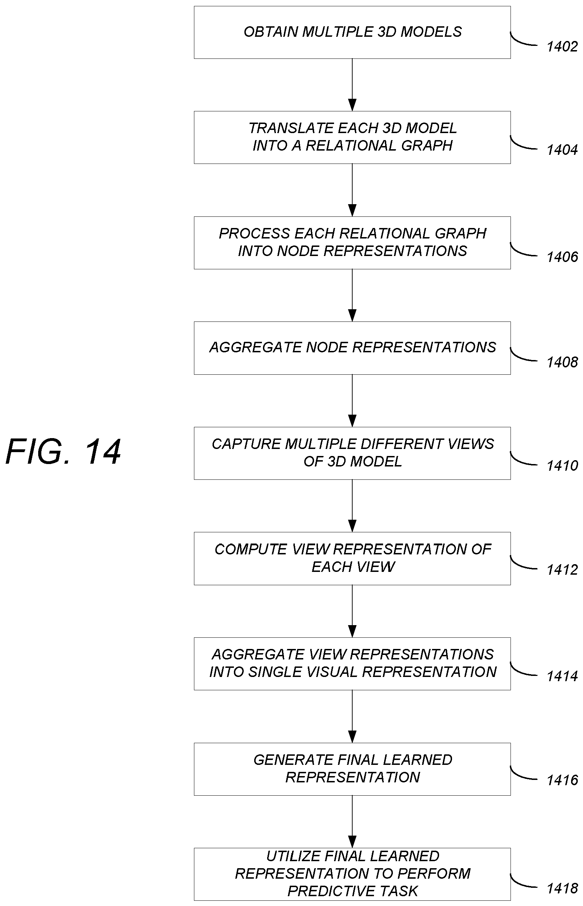

FIG. 14 illustrates the logical flow for utilizing 3D models to perform a predictive task in accordance with one or more embodiments of the invention.

At step 1402, multiple 3D models (e.g., BIM models) are obtained, with each 3D model consisting on non-Euclidean (e.g., complex) data.

At step 1404, each 3D model is translated into a relational graph. The relational graph consists of multiple nodes and at least one edge. Each of the multiple nodes corresponds to an element within the 3D model and a least one edge of the relational graph corresponds to a type of relation between a pair of the multiple nodes. In one or more embodiments, at least one of the multiple nodes has properties for the element it corresponds to, and the properties may include: an identification; a label; a type; a category; a bounding box; and an orientation.

At step 1406, each relational graph is processed using a graph neural network (GNN) that computes a node representation per node.

At step 1408, the node representations are aggregated into a structural representation of the 3D model.

At step 1410, multiple different views of the 3D model are captured. In one or more embodiments, each the multiple different views is a snapshot from a different camera angle of the 3D model.

At step 1412, the multiple different views are passed through/processed by a convolutional neural network (CNN) to compute a view representation of each of the multiple different views.

At step 1414, the view representations are aggregated into a single visual representation.

At step 1416, the GNN and CNN are trained using a multiview contrastive training objective to maximize agreement between the structural representation and the single visual representation to form final learned representations. In one or more embodiments, the training is performed end-to-end in a self-supervised manner.

In one or more embodiments, the structural representation and single visual representation both comprise a set of numbers that uniquely corresponds to the structural representation and single visual representation respectively.

At step 1418, the final learned representation is utilized to perform the predictive task. Multiple different types of predictive tasks are within the scope of embodiments of the invention. Some exemplary predictive tasks are described below.

In one exemplary predictive task, search input is received, and the final learned representations to utilized to identify a similar 3D model of one of the multiple 3D models based on the search input. Thereafter, the similar 3D model is provided in response to the search input.

In another exemplary predictive task, a new 3D model is received and clustered with at least one of the multiple 3D models based on the final learned representations. The clustering is then utilized to determine attributes of the new 3D model.

In yet another exemplary predictive task, a new 3D model is received, and a classification of the new 3D model is determined based on the final learned representations. Based on the classification and the final learned representations, a new attribute of the new 3D model is determined (e.g., the cost is determined as an attribute where the classification is that of commercial v. residential).

Hardware Embodiments

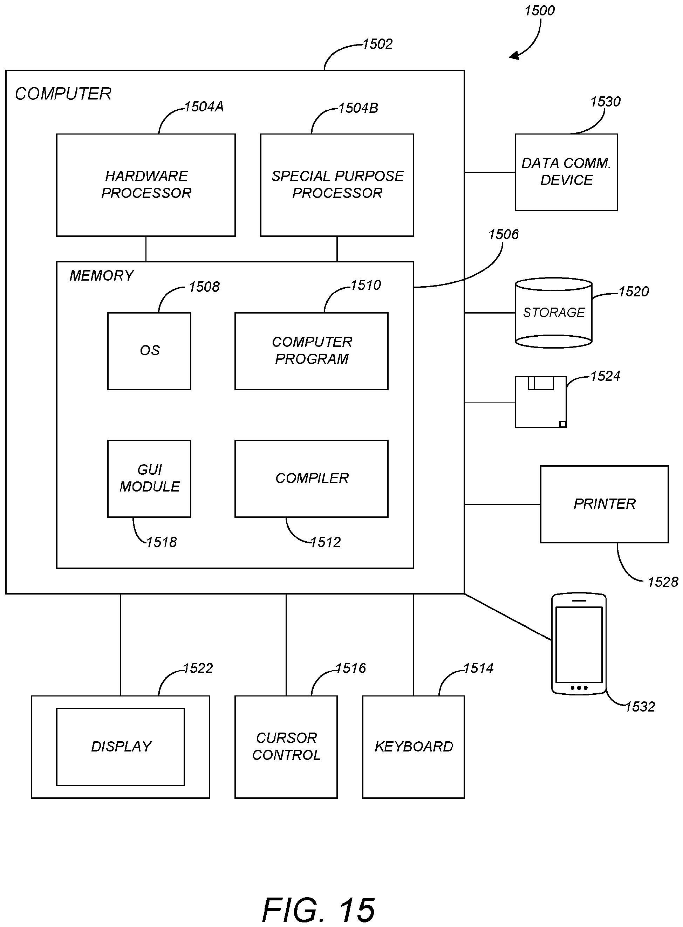

FIG. 15 is an exemplary hardware and software environment 1500 (referred to as a computer-implemented system and/or computer-implemented method) used to implement one or more embodiments of the invention. The hardware and software environment includes a computer 1502 and may include peripherals. Computer 1502 may be a user/client computer, server computer, or may be a database computer. The computer 1502 comprises a hardware processor 1504A and/or a special purpose hardware processor 1504B (hereinafter alternatively collectively referred to as processor 1504) and a memory 1506, such as random access memory (RAM). The computer 1502 may be coupled to, and/or integrated with, other devices, including input/output (I/O) devices such as a keyboard 1514, a cursor control device 1516 (e.g., a mouse, a pointing device, pen and tablet, touch screen, multi-touch device, etc.) and a printer 1528. In one or more embodiments, computer 1502 may be coupled to, or may comprise, a portable or media viewing/listening device 1532 (e.g., an MP3 player, IPOD, NOOK, portable digital video player, cellular device, personal digital assistant, etc.). In yet another embodiment, the computer 1502 may comprise a multi-touch device, mobile phone, gaming system, internet enabled television, television set top box, or other internet enabled device executing on various platforms and operating systems.

In one embodiment, the computer 1502 operates by the hardware processor 1504A performing instructions defined by the computer program 1510 (e.g., a computer-aided design [CAD] application) under control of an operating system 1508. The computer program 1510 and/or the operating system 1508 may be stored in the memory 1506 and may interface with the user and/or other devices to accept input and commands and, based on such input and commands and the instructions defined by the computer program 1510 and operating system 1508, to provide output and results.

Output/results may be presented on the display 1522 or provided to another device for presentation or further processing or action. In one embodiment, the display 1522 comprises a liquid crystal display (LCD) having a plurality of separately addressable liquid crystals. Alternatively, the display 1522 may comprise a light emitting diode (LED) display having clusters of red, green and blue diodes driven together to form full-color pixels. Each liquid crystal or pixel of the display 1522 changes to an opaque or translucent state to form a part of the image on the display in response to the data or information generated by the processor 1504 from the application of the instructions of the computer program 1510 and/or operating system 1508 to the input and commands. The image may be provided through a graphical user interface (GUI) module 1518. Although the GUI module 1518 is depicted as a separate module, the instructions performing the GUI functions can be resident or distributed in the operating system 1508, the computer program 1510, or implemented with special purpose memory and processors.

In one or more embodiments, the display 1522 is integrated with/into the computer 1502 and comprises a multi-touch device having a touch sensing surface (e.g., track pod or touch screen) with the ability to recognize the presence of two or more points of contact with the surface. Examples of multi-touch devices include mobile devices (e.g., IPHONE, NEXUS S, DROID devices, etc.), tablet computers (e.g., IPAD, HP TOUCHPAD, SURFACE Devices, etc.), portable/-handheld game/music/video player/console devices (e.g., IPOD TOUCH, MP3 players, NINTENDO SWITCH, PLAYSTATION PORTABLE, etc.), touch tables, and walls (e.g., where an image is projected through acrylic and/or glass, and the image is then backlit with LEDs).

Some or all of the operations performed by the computer 1502 according to the computer program 1510 instructions may be implemented in a special purpose processor 1504B. In this embodiment, some or all of the computer program 1510 instructions may be implemented via firmware instructions stored in a read only memory (ROM), a programmable read only memory (PROM) or flash memory within the special purpose processor 1504B or in memory 1506. The special purpose processor 1504B may also be hardwired through circuit design to perform some or all of the operations to implement the present invention. Further, the special purpose processor 1504B may be a hybrid processor, which includes dedicated circuitry for performing a subset of functions, and other circuits for performing more general functions such as responding to computer program 1510 instructions. In one embodiment, the special purpose processor 1504B is an application specific integrated circuit (ASIC).

The computer 1502 may also implement a compiler 1512 that allows an application or computer program 1510 written in a programming language such as C, C++, Assembly, SQL, PYTHON, PROLOG, MATLAB, RUBY, RAILS, HASKELL, or other language to be translated into processor 1504 readable code. Alternatively, the compiler 1512 may be an interpreter that executes instructions/source code directly, translates source code into an intermediate representation that is executed, or that executes stored precompiled code. Such source code may be written in a variety of programming languages such as JAVA, JAVASCRIPT, PERL, BASIC, etc. After completion, the application or computer program 1510 accesses and manipulates data accepted from I/O devices and stored in the memory 1506 of the computer 1502 using the relationships and logic that were generated using the compiler 1512.

The computer 1502 also optionally comprises an external communication device such as a modem, satellite link, Ethernet card, or other device for accepting input from, and providing output to, other computers 1502.

In one embodiment, instructions implementing the operating system 1508, the computer program 1510, and the compiler 1512 are tangibly embodied in a non-transitory computer-readable medium, e.g., data storage device 1520, which could include one or more fixed or removable data storage devices, such as a zip drive, floppy disc drive 1524, hard drive, CD-ROM drive, tape drive, etc. Further, the operating system 1508 and the computer program 1510 are comprised of computer program 1510 instructions which, when accessed, read and executed by the computer 1502, cause the computer 1502 to perform the steps necessary to implement and/or use the present invention or to load the program of instructions into a memory 1506, thus creating a special purpose data structure causing the computer 1502 to operate as a specially programmed computer executing the method steps described herein. Computer program 1510 and/or operating instructions may also be tangibly embodied in memory 1506 and/or data communications devices 1530, thereby making a computer program product or article of manufacture according to the invention. As such, the terms "article of manufacture," "program storage device," and "computer program product," as used herein, are intended to encompass a computer program accessible from any computer readable device or media.

Of course, those skilled in the art will recognize that any combination of the above components, or any number of different components, peripherals, and other devices, may be used with the computer 1502.

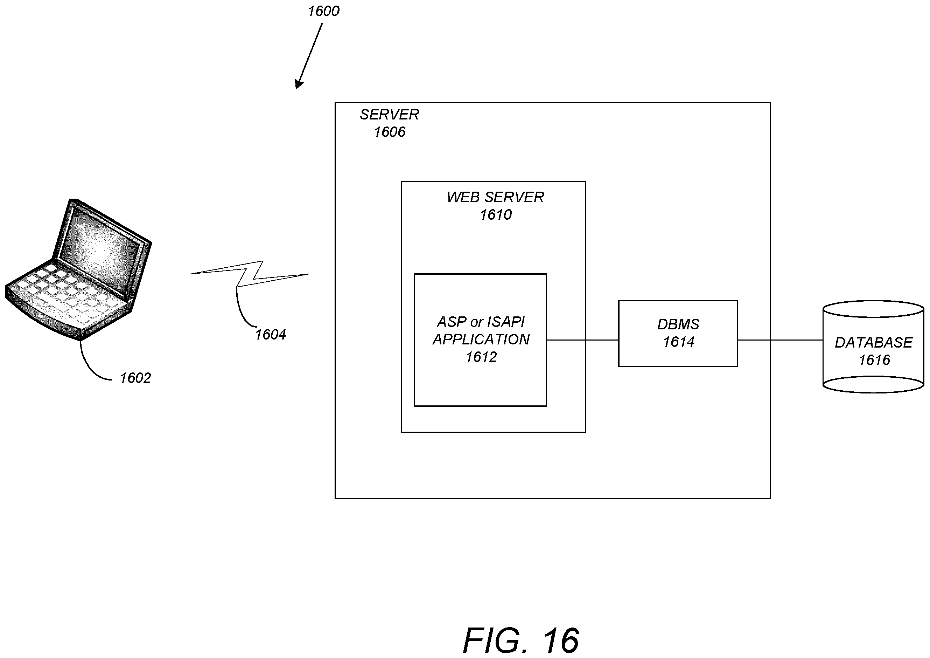

FIG. 16 schematically illustrates a typical distributed/cloud-based computer system 1600 using a network 1604 to connect client computers 1602 to server computers 1606. A typical combination of resources may include a network 1604 comprising the Internet, LANs (local area networks), WANs (wide area networks), SNA (systems network architecture) networks, or the like, clients 1602 that are personal computers or workstations (as set forth in FIG. 15), and servers 1606 that are personal computers, workstations, minicomputers, or mainframes (as set forth in FIG. 15). However, it may be noted that different networks such as a cellular network (e.g., GSM [global system for mobile communications] or otherwise), a satellite based network, or any other type of network may be used to connect clients 1602 and servers 1606 in accordance with embodiments of the invention.

A network 1604 such as the Internet connects clients 1602 to server computers 1606. Network 1604 may utilize ethernet, coaxial cable, wireless communications, radio frequency (RF), etc. to connect and provide the communication between clients 1602 and servers 1606. Further, in a cloud-based computing system, resources (e.g., storage, processors, applications, memory, infrastructure, etc.) in clients 1602 and server computers 1606 may be shared by clients 1602, server computers 1606, and users across one or more networks. Resources may be shared by multiple users and can be dynamically reallocated per demand. In this regard, cloud computing may be referred to as a model for enabling access to a shared pool of configurable computing resources.

Clients 1602 may execute a client application or web browser and communicate with server computers 1606 executing web servers 1610. Such a web browser is typically a program such as MICROSOFT INTERNET EXPLORER/EDGE, MOZILLA FIREFOX, OPERA, APPLE SAFARI, GOOGLE CHROME, etc. Further, the software executing on clients 1602 may be downloaded from server computer 1606 to client computers 1602 and installed as a plug-in or ACTIVEX control of a web browser. Accordingly, clients 1602 may utilize ACTIVEX components/component object model (COM) or distributed COM (DCOM) components to provide a user interface on a display of client 1602. The web server 1610 is typically a program such as MICROSOFT'S INTERNET INFORMATION SERVER.

Web server 1610 may host an Active Server Page (ASP) or Internet Server Application Programming Interface (ISAPI) application 1612, which may be executing scripts. The scripts invoke objects that execute business logic (referred to as business objects). The business objects then manipulate data in database 1616 through a database management system (DBMS) 1614. Alternatively, database 1616 may be part of, or connected directly to, client 1602 instead of communicating/obtaining the information from database 1616 across network 1604. When a developer encapsulates the business functionality into objects, the system may be referred to as a component object model (COM) system. Accordingly, the scripts executing on web server 1610 (and/or application 1612) invoke COM objects that implement the business logic. Further, server 1606 may utilize MICROSOFT'S TRANSACTION SERVER (MTS) to access required data stored in database 1616 via an interface such as ADO (Active Data Objects), OLE DB (Object Linking and Embedding DataBase), or ODBC (Open DataBase Connectivity).

Generally, these components 1600-1616 all comprise logic and/or data that is embodied in/or retrievable from device, medium, signal, or carrier, e.g., a data storage device, a data communications device, a remote computer or device coupled to the computer via a network or via another data communications device, etc. Moreover, this logic and/or data, when read, executed, and/or interpreted, results in the steps necessary to implement and/or use the present invention being performed.

Although the terms "user computer", "client computer", and/or "server computer" are referred to herein, it is understood that such computers 1602 and 1606 may be interchangeable and may further include thin client devices with limited or full processing capabilities, portable devices such as cell phones, notebook computers, pocket computers, multitouch devices, and/or any other devices with suitable processing, communication, and input/output capability.

Of course, those skilled in the art will recognize that any combination of the above components, or any number of different components, peripherals, and other devices, may be used with computers 1602 and 1606. Embodiments of the invention are implemented as a software/CAD application on a client 1602 or server computer 1606. Further, as described above, the client 1602 or server computer 1606 may comprise a thin client device or a portable device that has a multitouch-based display.

Enumerated Example Embodiments

Further examples of embodiments of the present invention are defined, without limitation, by the following Example Enumerated Embodiments (EEEs):

EEE 1: A computer-implemented method for utilizing three-dimensional (3D) models to perform a predictive task, comprising:

obtaining multiple 3D models, wherein each 3D model comprises non-Euclidian data;
translating each 3D model into a relational graph comprising multiple nodes and at least one edge, wherein each of the multiple nodes corresponds to an element within the 3D model and a least one edge of the relational graph corresponds to a type of relation between a pair of the multiple nodes;
processing each relational graph using a graph neural network (GNN) that computes a node representation per node;
aggregating the node representations into a structural representation of the 3D model;
capturing multiple different views of the 3D model;
passing the multiple different views through a convolutional neural network (CNN) to compute a view representation of each of the multiple different views;
aggregating the view representations into a single visual representation;
training the GNN and CNN using a multiview contrastive training objective to maximize agreement between the structural representation and the single visual representation to form final learned representations; and
utilizing the final learned representation to perform the predictive task.

EEE 2: The computer-implemented method of EEE 1, wherein the 3D model comprises a building information model (BIM).

EEE 3: The computer-implemented method of EEE 1 or EEE 2, wherein at least one of the multiple nodes has properties for the element it corresponds to, and the properties comprise:

an identification;
a label;
a type;
a category;
a bounding box; and
an orientation.

EEE 4: The computer-implemented method of any of EEEs 1-3, wherein each the multiple different views comprises a snapshot from a different camera angle of the 3D model.

EEE 5: The computer-implemented method of any of EEEs 1-4, wherein the training is performed end-to-end in a self-supervised manner.

EEE 6: The computer-implemented method of any of EEEs 1-5, wherein the structural representation and single visual representation both comprise a set of numbers that uniquely corresponds to the structural representation and single visual representation respectively.

EEE 7: The computer-implemented method of any of EEEs 1-6, wherein the performing the predictive task comprises:

receiving search input;
utilizing the learned final learned representations to identify a similar 3D model of one of the multiple 3D models based on the search input; and
providing the similar 3D model in response to the search input.

EEE 8: The computer-implemented method of any of EEEs 1-7, wherein the performing the predictive task comprises:

receiving a new 3D model;
clustering the new 3D model with at least one of the multiple 3D models based on the final learned representations; and
utilizing the clustering to determine attributes of the new 3D model.

EEE 9: The computer-implemented method of any of EEEs 1-8, wherein the performing the predictive task comprises:

receiving a new 3D model;
determining a classification of the new 3D model based on the final learned representations;
based on the classification and the final learned representations, determining a new attribute of the new 3D model.

EEE 10: A computer-implemented system for utilizing three-dimensional (3D) models to perform a predictive task, comprising:

(a) a computer having a memory;
(b) a processor executing on the computer;
(c) the memory storing a set of instructions, wherein the set of instructions, when executed by the processor cause the processor to perform operations comprising:

(1) obtaining multiple 3D models, wherein each 3D model comprises non-Euclidian data;
(2) translating each 3D model into a relational graph comprising multiple nodes and at least one edge, wherein each of the multiple nodes corresponds to an element within the 3D model and a least one edge of the relational graph corresponds to a type of relation between a pair of the multiple nodes;
(3) processing each relational graph using a graph neural network (GNN) that computes a node representation per node;
(4) aggregating the node representations into a structural representation of the 3D model;
(5) capturing multiple different views of the 3D model;
(6) passing the multiple different views through a convolutional neural network (CNN) to compute a view representation of each of the multiple different views;
(7) aggregating the view representations into a single visual representation;
(8) training the GNN and CNN using a multiview contrastive training objective to maximize agreement between the structural representation and the single visual representation to form final learned representations; and
(9) utilizing the final learned representation to perform the predictive task.

EEE 11: The computer-implemented system of EEE 10, wherein the 3D model comprises a building information model (BIM).

EEE 12: The computer-implemented system of EEE 10 or EEE 11, wherein at least one of the multiple nodes has properties for the element it corresponds to, and the properties comprise:

an identification;
a label;
a type;
a category;
a bounding box; and
an orientation.

EEE 13: The computer-implemented system of any of EEEs 10-12, wherein each the multiple different views comprises a snapshot from a different camera angle of the 3D model.

EEE 14: The computer-implemented system of any of EEEs 10-13, wherein the operation training is performed end-to-end in a self-supervised manner.

EEE 15: The computer-implemented system of any of EEEs 10-14, wherein the structural representation and single visual representation both comprise a set of numbers that uniquely corresponds to the structural representation and single visual representation respectively.

EEE 16: The computer-implemented system of any of EEEs 10-15, wherein the operation performing the predictive task comprises:

receiving search input;
utilizing the learned final learned representations to identify a similar 3D model of one of the multiple 3D models based on the search input; and
providing the similar 3D model in response to the search input.

EEE 17: The computer-implemented system of any of EEEs 10-16, wherein the operation performing the predictive task comprises:

receiving a new 3D model;
clustering the new 3D model with at least one of the multiple 3D models based on the final learned representations; and
utilizing the clustering to determine attributes of the new 3D model.

EEE 18: The computer-implemented system of any of EEEs 10-17, wherein the operation performing the predictive task comprises:

receiving a new 3D model;
determining a classification of the new 3D model based on the final learned representations;
based on the classification and the final learned representations, determining a new attribute of the new 3D model.

Conclusion

This concludes the description of the preferred embodiment of the invention. In view of the above, embodiments of the invention provide the ability to lean representations over complex 3D BIM models (e.g., where a BIM model is represented by/mapped to a set numbers). In addition to use for BIM models, embodiments of the invention may also be utilized with computer aided design (CAD) models or 3D CAD, modeling, manufacturing, industrial design, electronics, and mechanical engineering models/applications. Further embodiments may be utilized to infer properties/attributes for any type of complex models such as movie characters, 3D animation and characters (e.g., in AUTODESK MAYA), etc.
Further, embodiments of the invention may be implemented on any type of computer, such as a mainframe, minicomputer, or personal computer, or computer configuration, such as a timesharing mainframe, local area network, or standalone personal computer, could be used with the present invention.
The foregoing description of the preferred embodiment of the invention has been presented for the purposes of illustration and description. It is not intended to be exhaustive or to limit the invention to the precise form disclosed. Many modifications and variations are possible in light of the above teaching. It is intended that the scope of the invention be limited not by this detailed description, but rather by the claims appended hereto.

References

[1] Su, Hang, et al. "Multi-view convolutional neural networks for 3d shape recognition." Proceedings of the IEEE international conference on computer vision. 2015.
[2] Xu, Keyulu, et al. "How powerful are graph neural networks?." arXiv preprint arXiv:1810.00826 (2018).
[3] Hassani, Kaveh, and Amir Hosein Khasahmadi. "Contrastive multi-view representation learning on graphs." International conference on machine learning. PMI,R, 2020.

**Claims**

1. A computer-implemented method for utilizing three-dimensional (3D) models to perform a predictive task, comprising:

obtaining multiple 3D models, wherein each 3D model comprises non-Euclidian data;
translating each 3D model into a relational graph comprising multiple nodes and at least one edge, wherein each of the multiple nodes corresponds to an element within the 3D model and a least one edge of the relational graph corresponds to a type of relation between a pair of the multiple nodes;

processing each relational graph using a graph neural network (GNN) that computes a node representation per node;

aggregating the node representations into a structural representation of the 3D model;

capturing multiple different views of the 3D model;

passing the multiple different views through a convolutional neural network (CNN) to compute a view representation of each of the multiple different views;

aggregating the view representations into a single visual representation;

training the GNN and CNN using a multiview contrastive training objective to maximize agreement between the structural representation and the single visual representation to form final learned representations; and

utilizing the final learned representation to perform the predictive task.

2. The computer-implemented method of claim 1, wherein the 3D model comprises a building information model (BIM).

3. The computer-implemented method of claim 1 or claim 2, wherein at least one of the multiple nodes has properties for the element it corresponds to, and the properties comprise:

an identification;
a label;
a type;
a category;
a bounding box; and
an orientation.

4. The computer-implemented method of any of claims 1-3, wherein each the multiple different views comprises a snapshot from a different camera angle of the 3D model.

5. The computer-implemented method of any of claims 1-4, wherein the training is performed end-to-end in a self-supervised manner.

6. The computer-implemented method of any of claims 1-5, wherein the structural representation and single visual representation both comprise a set of numbers that uniquely corresponds to the structural representation and single visual representation respectively.

7. The computer-implemented method of any of claims 1-6, wherein the performing the predictive task comprises:

receiving search input;
utilizing the learned final learned representations to identify a similar 3D model of one of the multiple 3D models based on the search input; and
providing the similar 3D model in response to the search input.

8. The computer-implemented method of any of claims 1-7, wherein the performing the predictive task comprises:

receiving a new 3D model;
clustering the new 3D model with at least one of the multiple 3D models based on the final learned representations; and
utilizing the clustering to determine attributes of the new 3D model.

9. The computer-implemented method of any of claims 1-8, wherein the performing the predictive task comprises:

receiving a new 3D model;
determining a classification of the new 3D model based on the final learned representations;
based on the classification and the final learned representations, determining a new attribute of the new 3D model.

10. A computer-implemented system for utilizing three-dimensional (3D) models to perform a predictive task, comprising:

(a) a computer having a memory;
(b) a processor executing on the computer;

(c) the memory storing a set of instructions, wherein the set of instructions, when executed by the processor cause the processor to perform operations comprising the operations recited in any of claims 1-9.

11. A computer program comprising instructions which, when the program is executed by one or more computers, cause the one or more computers to carry out operations which comprise the operations recited in any of claims 1-9.

12. A computer-readable medium comprising instructions which, when executed by one or more computers, cause the one or more computers to carry out operations which comprise the operations recited in any of claims 1-9.

FIG. 1

*FIG. 2*

Node Attributes *210*
- ID
- Label
- Type
- Category
- Bounding Box
- Orientation

Edge Attribute *212*
- Relation

*304A*
- -352753250424429328
- Magnetic - Ivory
- Instance
- Material
- [[0.0,0.0, 0.0], [0.0, 0.0, 0.0]]
- [0.0, 0.0, 0.0]

*302A*

*306*
- Made of

*304B*
- 8454925988328030555
- Bathtub - Rectangular - 1525 x 762 mm
- Instance
- Plumbing Fixtures
- [[-4.46,-7.02, 0.0], [-1.96, -2.02, 1.25]]
- [-1, 0, 0]

*302B*

Node Attributes
- ID
- Label
- Type
- Category
- Bounding Box
- Orientation

Edge Attribute
- Relation

EP 4 517 587 A1

## FIG. 3

FIG. 4

EP 4 517 587 A1

*502*

Min: 109
Max: 603
Mean: 182.78
Variance: 1242.66
Skewness: 5.22
Kurtosis: 56.14

*504*

Min: 810
Max: 9140
Mean: 1985.04
Variance: 294420.09
Skewness: 6.66
Kurtosis: 82.26

*FIG. 5*

## FIG. 6A

## FIG. 6B

$$h_v^{(k)} = \text{COMBINE}^{(k)}\left(h_v^{(k-1)}, \text{AGGREGATE}^{(k)}\left(\left\{\left(h_v^{(k-1)}, h_u^{(k-1)}, e_{uv}\right) : u \in \mathcal{N}(v)\right\}\right)\right)$$

$$h_G = \text{READOUT}\left(\left\{h_v^{(K)} \mid v \in G\right\}\right)$$

GNN
704

Pool
708

Initial Attributes
702

Node Representations
706

Graph Representation
710

## FIG. 7

Pretrained ResNet Backbone
*806*

CNN
*804*

Views of a BIM Model
*802*

View Representations
*808*

Pool
*810*

Visual Representation
*812*

*FIG. 8*

Representation 902

710

812

Pool 708

Pool 810

706

808

GNN 704

CNN 804

702

802

BIM Model

202

FIG. 9

24

FIG. 10A

BIM Model
202

Encoder
1000

GNN 704    Pool 708

CNN 804    Pool 810

Representation
902

Head
1002

Fine-tune
1004

Commercial
Residential
1006

FIG. 10B

BIM Model
202

Encoder
1000

GNN 704    Pool 708

CNN 804    Pool 810

Representation
902

Head
1002

Fine-tune
1004

Cost
1008

EP 4 517 587 A1

*FIG. 10C*

FIG. 11

*FIG. 12*

FIG. 13

```
                        ┌──────────────────────────────────┐
                        │      OBTAIN MULTIPLE 3D MODELS     │───  1402
                        └──────────────────────────────────┘
                                        │
                                        ▼
                        ┌──────────────────────────────────┐
                        │       TRANSLATE EACH 3D MODEL      │
                        │       INTO A RELATIONAL GRAPH      │───  1404
                        └──────────────────────────────────┘
                                        │
                                        ▼
                        ┌──────────────────────────────────┐
                        │    PROCESS EACH RELATIONAL GRAPH   │
                        │      INTO NODE REPRESENTATIONS     │───  1406
                        └──────────────────────────────────┘
                                        │
                                        ▼
                        ┌──────────────────────────────────┐
                        │    AGGREGATE NODE REPRESENTATIONS  │───  1408
                        └──────────────────────────────────┘
                                        │
                                        ▼
                        ┌──────────────────────────────────┐
                        │   CAPTURE MULTIPLE DIFFERENT VIEWS │
                        │            OF 3D MODEL             │───  1410
                        └──────────────────────────────────┘
                                        │
                                        ▼
                        ┌──────────────────────────────────┐
                        │   COMPUTE VIEW REPRESENTATION OF   │
                        │             EACH VIEW             │───  1412
                        └──────────────────────────────────┘
                                        │
                                        ▼
                        ┌──────────────────────────────────┐
                        │   AGGREGATE VIEW REPRESENTATIONS   │
                        │  INTO SINGLE VISUAL REPRESENTATION │───  1414
                        └──────────────────────────────────┘
                                        │
                                        ▼
                        ┌──────────────────────────────────┐
                        │      GENERATE FINAL LEARNED        │
                        │          REPRESENTATION           │───  1416
                        └──────────────────────────────────┘
                                        │
                                        ▼
                        ┌──────────────────────────────────┐
                        │      UTILIZE FINAL LEARNED         │
                        │   REPRESENTATION TO PERFORM        │
                        │          PREDICTIVE TASK          │───  1418
                        └──────────────────────────────────┘
```

*FIG. 14*

FIG. 15

FIG. 16

EP 4 517 587 A1

Europäisches
Patentamt

European
Patent Office

Office européen
des brevets

# EUROPEAN SEARCH REPORT

Application Number

EP 24 19 4641

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JOSHI RUCHA BHALCHANDRA ET AL: "eBIM-GNN Fast and Scalable energy analysis through BIMs and Graph Neural Networks", 2022 IEEE 7TH INTERNATIONAL ENERGY CONFERENCE (ENERGYCON), IEEE, 9 May 2022 (2022-05-09), pages 1-8, XP034154161, DOI: 10.1109/ENERGYCON53164.2022.9830484 [retrieved on 2022-07-21] * the whole document * | 1-12 | INV. G06N3/045 G06N3/08 G06T17/00 |
| A | YAOCHEN XIE ET AL: "Self-Supervised Learning of Graph Neural Networks: A Unified Review", ARXIV.ORG, CORNELL UNIVERSITY LIBRARY, 201 OLIN LIBRARY CORNELL UNIVERSITY ITHACA, NY 14853, 25 April 2022 (2022-04-25), XP091189860, * Sections 1, 3; figures 1,2 * | 1-12 | |
| A | US 2022/318636 A1 (JAYARAMAN PRADEEP KUMAR [CA] ET AL) 6 October 2022 (2022-10-06) * paragraphs [0049] - [0056], [0061] - [0063] * * claims 3-4, 6, 7 * | 1-12 | TECHNICAL FIELDS SEARCHED (IPC) G06N G06T |

The present search report has been drawn up for all claims

| Place of search | Date of completion of the search | Examiner |
|---|---|---|
| The Hague | 14 January 2025 | Mariani, Giovanni |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 24 19 4641

This annex lists the patent family members relating to the patent documents cited in the above-mentioned European search report.
The members are as contained in the European Patent Office EDP file on
The European Patent Office is in no way liable for these particulars which are merely given for the purpose of information.

14-01-2025

| Patent document cited in search report | Publication date | Patent family member(s) | | Publication date |
|---|---|---|---|---|
| US 2022318636 A1 | 06-10-2022 | US | 2022318636 A1 | 06-10-2022 |
| | | US | 2022318637 A1 | 06-10-2022 |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **SU, HANG et al.** Multi-view convolutional neural networks for 3d shape recognition. *Proceedings of the IEEE international conference on computer vision.*, 2015
- **XU, KEYULU et al.** How powerful are graph neural networks?.. *arXiv preprint arXiv:1810.00826*, 2018

- **HASSANI, KAVEH ; AMIR HOSEIN KHASAHMADI**. Contrastive multi-view representation learning on graphs.. *International conference on machine learning. PMI,R*, 2020